**Europäisches Patentamt**

**European Patent Office**

**Office européen des brevets**

(19)

(11) Numéro de publication: **0 240 435 B1**

# (12) FASCICULE DE BREVET EUROPEEN

(45) Date de publication de fascicule du brevet: **28.08.91**

(51) Int. Cl.5: **H01L 29/86**

(21) Numéro de dépôt: **87400742.0**

(22) Date de dépôt: **03.04.87**

(54) **Résistance intégrée sur un substrat semiconducteur.**

(30) Priorité: **04.04.86 FR 8604858**

(43) Date de publication de la demande:
**07.10.87 Bulletin 87/41**

(45) Mention de la délivrance du brevet:
**28.08.91 Bulletin 91/35**

(84) Etats contractants désignés:
**BE DE ES GB IT NL SE**

(56) Documents cités:
**FR-A- 1 539 871**
**US-A- 4 139 833**
**US-A- 4 212 025**

**ELECTRONICS, vol. 38, no. 9, 3 mai 1965,
pages 48-59, New York, US; R.M. BURGER et
al.: "A broader choice of components for
silicon integrated circuits"**

(73) Titulaire: **THOMSON-CSF**
**51, Esplanade du Général de Gaulle**
**F-92800 Puteaux(FR)**

(72) Inventeur: **Nadd, Bruno**
**THOMSON-CSF SCPI 19, avenue de Messine**
**F-75008 Paris(FR)**

(74) Mandataire: **Guérin, Michel et al**
**THOMSON-CSF SCPI**
**F-92045 PARIS LA DEFENSE CEDEX 67(FR)**

## Description

La présente invention concerne une résistance intégrée sur un substrat semiconducteur et notamment une résistance susceptible d'avoir l'une de ses extrémités connectée à un point du substrat soumis à un potentiel élevé.

Dans de nombreuses applications concernant les structures semiconductrices associant un transistor de puissance et sa logique de commande et/ou de protection, encore désignées sous l'appellation "commutateurs de puissance intelligents", il est souhaitable de pouvoir disposer de résistances connectées au drain ou au collecteur du transistor de puissance. Si le transistor de puissance est du type VD MOS ou bipolaire à conduction verticale, la face arrière du substrat supportant le contact de drain ou de collecteur est donc au potentiel de ce drain ou de ce collecteur. Un circuit d'allumage électronique pour l'automobile réalisé sous forme monolithique peut nécessiter un pont diviseur de tension à résistances supportant une tension de l'ordre de 400 V pour commander la remise en conduction du transistor de puissance en cas de surtension. La réalisation d'une telle résistance se heurte à de sérieuses difficultés d'isolement si l'on ne veut pas mettre en oeuvre, dans le procédé de fabrication, certaines étapes particulières destinées à assurer un isolement par écran physique.

De façon générale, on connaît différentes méthodes d'intégration d'une résistance sur un substrat semiconducteur de polarité déterminée. On peut utiliser la résistance propre d'une couche épitaxiée, mais ceci conduit à des valeurs de résistance difficiles à contrôler et ne permet pas de faire des ponts diviseurs. On peut également réaliser cette résistance grâce à un caisson diffusé de polarité opposée au substrat. Si cette solution permet un contrôle précis de la valeur de la résistance, elle nécessite par contre la mise en oeuvre d'étapes particulières destinées à assurer son isolement physique et ces étapes ne sont pas désirées. Sans cet isolement physique, une telle résistance entraînerait, dans le cas d'un dispositif fonctionnant en haute tension (par exemple 400 V), un claquage de la jonction existant entre le substrat et le caisson et dû à la courbure excessive des équipotentielles. En effet, la connexion de la résistance ainsi constituée à la face arrière du substrat mis au potentiel de la haute tension implique une remontée des équipotentielles jusqu'à la face avant du substrat et certaines de ces équipotentielles présentent un rayon de courbure très faible.

Afin de pallier ces inconvénients, l'invention propose de réaliser une résistance intégrée par un caisson de polarité inverse à celle du substrat, ayant la forme d'un ruban enroulé autour de l'une de ses extrémités qui est rattachée à un pôle conducteur. Ce pôle conducteur permet la liaison électrique avec la face arrière du substrat à travers celui-ci. Le ruban fait à la fois office de résistance et d'anneaux répartiteurs de champ, ce qui permet d'éviter la courbure excessive des équipotentielles.

L'invention a donc pour objet une résistance intégrée sur un substrat semiconducteur d'un type de conductivité donné, la résistance étant élaborée sur la première face du substrat et devant être connectée à une tension élevée disponible sur la seconde face du substrat, la résistance étant constitué par un caisson de type de conductivité opposé à celui du substrat, caractérisée en ce que :

- le caisson constituant la résistance a la forme d'un ruban enroulé sur lui-même autour d'un pôle conducteur auquel l'une de ses extrémités est reliée électriquement,
- la connexion avec la face arrière du substrat s'effectue à travers l'épaisseur du substrat par l'intermédiaire du pôle conducteur.

Le ruban est avantageusement prolongé et entouré, à partir de son autre extrémité, d'une partie constituée par le même caisson et destinée à répartir autour du ruban le potentiel de cette autre extrémité.

L'invention sera mieux comprise et d'autres avantages apparaîtront au moyen de la description qui va suivre et des figures annexées parmi lesquelles :

- la figure 1 est un schéma électrique d'un circuit d'allumage électronique selon l'art connu,
- les figures 2 et 3 sont des vues respectivement de dessus et de profil d'une résistance selon l'invention,
- la figure 4 est une vue de détail d'une résistance selon l'invention et possédant un point intermédiaire.

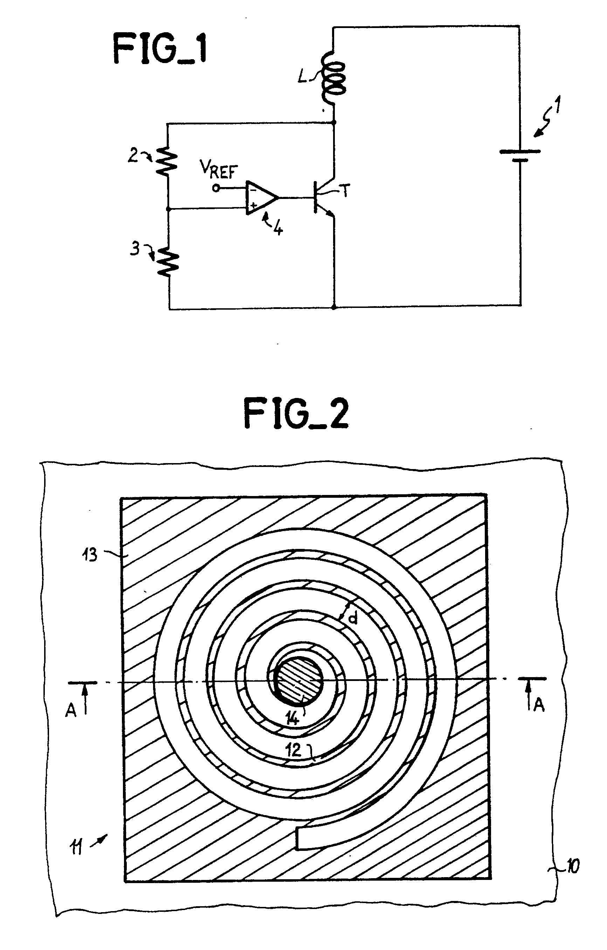

Un exemple de dispositif où l'intégration de résistances serait le bienvenu est constitué par un circuit d'allumage électronique pour l'automobile. Un tel circuit comprend une bobine d'allumage en série avec un transistor de puissance. Ce circuit doit également comporter un dispositif permettant l'écrêtage des surtensions. Un écrêtage par diode Zener est difficilement envisageable à cause de la difficulté que présente cet élément à l'intégration. Une autre solution consiste en un pont diviseur de tension à résistances associé à un comparateur. C'est ce que représente le schéma de la figure 1. La bobine d'allumage L et le transistor T sont disposés en série et branchés aux bornes de la batterie 1. Aux bornes du transistor T, entre émetteur et collecteur, sont branchées deux résistances 2 et 3 montées en série. Le point commun à ces deux résistances est connecté à l'une des entrées d'un comparateur 4 qui reçoit sur sa seconde entrée la tension de référence V$_{REF}$. La sortie du comparaeur 4 attaque la base du transistor T. Le dispositif constitué par les résistances 2 et 3 et par le comparateur 4 permet la remise en conduction du transistor T pour écrêter les surtensions. Bien que la tension de batterie soit relativement faible, le pont diviseur doit pouvoir supporter des tensions élevées (de l'ordre de 400 V) dues à la présence de la bobine d'allumage L. Les résistances constituant le pont diviseur doivent donc être des résistances haute tension. Si le comparateur ne pose pas de problème d'intégration, il n'en est pas de même pour le pont diviseur pour les raisons exposées plus haut.

Une résistance selon l'invention est obtenue par diffusion ou par implantation d'un caisson de polarité opposée au substrat. Ce caisson est formé principalement d'un ruban de largeur réduite par rapport à sa longueur ce qui permet d'obtenir la valeur de résistance désirée. Il a avantageusement la forme d'une spirale à grand nombre de tours. La répartition des équipotentielles dépendra à la fois du nombre de tours ou de spires et de la distance séparant deux spires consécutives. Dans le cas d'un pont diviseur de tension à résistances, il est possible de disposer d'une connexion intermédiaire.

La suite de la description portera sur l'intégration de résistances haute tension dans le cas d'un substrat en silicium de type N mais l'invention s'applique également à d'autres types de substrats.

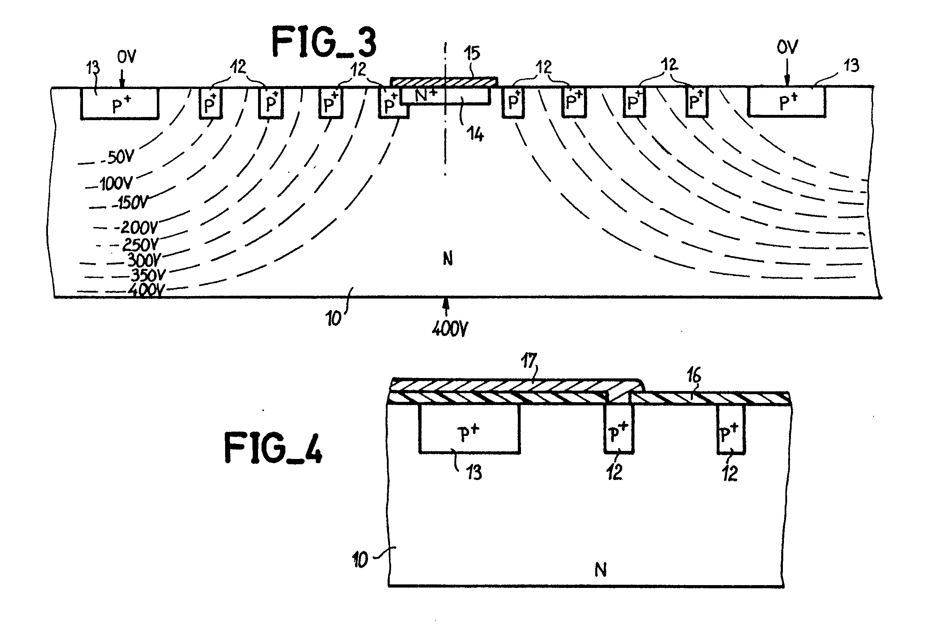

Les figures 2 et 3 sont des vues respectivement de dessus et de profil d'un substrat semiconducteur supportant une résistance selon l'invention. On part d'un substrat 10 en silicium, par exemple de type N$^+$ possédant une couche épitaxiée de type N. Sur ce substrat, on a diffusé, grâce à un masque de forme appropriée, un caisson 11 de type P$^+$ afin de réaliser la résistance selon l'invention. Sur la figure 2, on n'a représenté que quelques spires pour des commodités de représentation, mais la résistance peut en comporter beaucoup plus. Le caisson P$^+$ comporte donc une partie 12 en spirale qui est de préférence prolongée et entourée d'une partie 13 assurant une continuité électrostatique autour de la spirale 12. On peut ensuite diffuser un caisson 14 de type N$^+$ au centre de la spirale pour former le pôle conducteur. La résistance intégrée ayant une forme en spirale, le caisson 14 sera de préférence en forme de disque pour que les équipotentielles puissent se répartir de façon symétrique. Le caisson 14 permet une liaison électrique peu résistive avec la face arrière du substrat 10 sur laquelle une haute tension sera disponible.

La figure 3 est une coupe selon l'axe AA du substrat de la figure 2. Sur la figure 3, un plot conducteur 15 de forme circulaire a été déposé au centre de la spirale et sur le caisson 14 en débordant sur l'extrémité de la spirale. Il permet la liaison électrique entre le caisson 14 de type N$^+$ et la spirale 12 de type P$^+$. Sur la figure 3 on a également représenté les équipotentielles en traits pointillés pour une tension de 400 V appliquée sur la face arrière du substrat et pour une tension nulle appliquée sur la partie 13 du caisson P$^+$. La spirale fait à la fois office de résistance et d'anneaux répartiteurs de champ. En effet, le potentiel varie linéairement de l'extérieur vers l'intérieur de la spirale. Sur la partie gauche de la figure, on a représenté des équipotentielles qui varient par bond de 50 V entre 0 et 400 V. D'autres équipotentielles ont été représentées sur la partie droite de la figure sans préciser la valeur des tensions auxquelles elles correspondent. La différence de potentiel entre deux tours consécutifs n'est donc qu'une fraction de la haute tension et la remontée des équipotentielles se fait graduellement selon des rayons de courbure élevés permettant d'éviter le claquage.

Un élément important intervient dans la conception de la spirale : c'est la distance d séparant chaque spire ou la dernière spire de la partie 13. Cette distance d ne doit pas être supérieure à une distance limite qui peut être calculée d'après les règles de l'art connu en tenant compte de certains paramètres : tension maximale admissible, nature et qualité de l'isolement de surface, dimensions du caisson P$^+$ envisagé, etc. Si la distance d est supérieure à cette distance limite, la courbure des équipotentielles sera telle qu'elle entraînera un claquage en surface ou en volume pour une tension inférieure à la tension maximale admissible.

La partie 13 du caisson P$^+$ constitue l'autre extrémité de la résistance et est alors connectée au point désiré. Dans l'exemple de l'application schématisée en figure 1, ce caisson P$^+$ est connecté à l'émetteur du transistor de puissance par un cordon métallique déposé au-dessus d'un diélectrique assurant l'isolement. Il est possible de se connecter à un endroit quelconque de la spirale pour réaliser un pont diviseur de tension. C'est ce que montre la figure 4 qui est un agrandissement d'une partie de la figure 3. Sur la face avant du substrat 10 dans lequel on a diffusé la résistance selon l'invention, on a déposé une couche 16 d'un isolant de passivation tel que l'oxyde de silicium SiO$_2$. Un trou de contact a été gravé dans la couche 16 afin de permettre l'accès à un point de la spirale 12. Une couche 17 en matériau conducteur permet de réaliser la prise de contact intermédiaire avec la spirale 12.

Il entre dans le cadre de l'invention de réaliser la résistance par des opérations d'implantation ou de diffusion. Il faut remarquer que son élaboration peut bénéficier des opérations nécessaires à la fabrication sur le même substrat de transistors bipolaires ou du type VD MOS de même que d'autres éléments de circuits logiques.

Enfin, si la description a porté sur une résistance en forme de spirale, on peut très bien concevoir d'autres formes d'enroulements par exemple en forme de grecque.

**Revendications**

1. Résistance intégrée sur un substrat semiconducteur d'un type de conductivité donné (10), la résistance étant élaborée sur la première face du substrat et devant être connectée à une tension élevée disponible sur la seconde face du substrat, la résistance étant constituée par un caisson de type de conductivité opposé à celui du substrat, caractérisée en ce que :
   - le caisson (11) constituant la résistance a la forme d'un ruban (12) enroulé sur lui-même autour d'un pôle conducteur (14) auquel l'une de ses extrémités est reliée électriquement,
   - la connexion avec la face arrière du substrat s'effectue à travers l'épaisseur du substrat par l'intermédiaire du pôle conducteur (14).

2. Résistance intégrée selon la revendication 1, caractérisée en ce que, à partir de son autre extrémité, le ruban (12) est prolongé et entouré d'une partie (13) constituée par le même caisson (11) et destinée à répartir autour du ruban le potentiel de cette autre extrémité.

3. Résistance intégrée selon l'une des revendications 1 ou 2, caractérisée en ce que le ruban (12) est une spirale.

4. Résistance intégrée selon la revendication 3, caractérisée en ce que le pôle conducteur (14) a une forme circulaire.

5. Résistance intégrée selon l'une quelconque des revendications 1 à 4, caractérisée en ce que le pôle conducteur (14) est formé par un caisson fortement dopé et de même type de conductivité que le substrat (10) et la liaison électrique entre l'extrémité du ruban (12) et le pôle conducteur (14) se fait par l'intermédiaire d'un plot conducteur (15).

6. Résistance intégrée selon l'une quelconque des revendications 1 à 5, caractérisée en ce que le substrat (10) est de type N$^+$ comprenant une couche épitaxiée du type N, le caisson (11) constituant la résistance étant de type P$^+$ et le pôle conducteur (14) étant un caisson de type N$^+$.

7. Résistance intégrée selon l'une quelconque des revendications 1 à 6, caractérisée en ce qu'au moins une prise intermédiaire (17) permet une prise de contact sur le ruban (12) pour réaliser un pont diviseur.

**Claims**

1. A resistor integrated on a semiconductor substrate (10) of a given conductivity type, the resistor being formed on a first face of the substrate and connected to a voltage available on the second face of the substrate, the resistor being formed by a well of the opposite conductivity type of that of the substrate, characterized in this that:
   - the well (11) forming the resistor is in the form of a ribbon (12) wound on itself about a conducting pole (14) to which one of its ends is connected electrically,
   - the connection with the rear face of the substrate takes place through the thickness of the substrate via the conducting pole (14).

2. The integrated resistor as claimed in claim 1, characterized in this that, from its other end, the ribbon (12) is extended and surrounded by a part (13) formed by the same well (11) and intended to distribute the potential of this other end about the ribbon.

3. The integrated resistor as claimed in claim 1 or 2, characterized in this that said ribbon (12) is a spiral.

4. The integrated resistor as claimed in claim 3, characterized in this that said conducting pole (14) has a circular form.

5. The integrated resistor as claimed in any of claims 1 to 4, characterized in this that said conducting pole (14) is formed by a heavily doped well of the same conductivity type as the substrate and characterized in this that the electric connection between the end of the ribbon (12) and said conducting pole takes place through a conducting stud (15).

6. The integrated resistor as claimed in any of claims 1 to 5, characterized in this that the substrate (10) is of N$^+$ type comprising an N type epitaxial layer, the well (11) forming the resistor being of P$^+$ type and the conducting pole (14) being a well of N$^+$ type.

7. The integrated resistor as claimed in any of claims 1 to 6, characterized in this that at least an intermediate tap (17) allows contact to be made with the ribbon (12) for forming a divider bridge.

## Patentansprüche

1. Integrierter Widerstand auf einem Halbleitersubstrat von vorgegebenem Leitungstyp, wobei der Widerstand auf einer ersten Fläche des Substrats aufgebaut und mit einer erhöhten Spannung verbunden ist, die auf der Zweiten Fläche des Substrats zur Verfügung steht, und wobei der Widerstand durch einen Graben von zum Substrat entgegengesetztem Leitungstyp gebildet ist, dadurch gekennzeichnet, daß
   - der Graben (11), der den Widerstand bildet, die Form eines um einen leitenden Pol (14) gewickelten Bandes (12) aufweist und mit einem seiner Enden mit dem Pol (14) elektrisch verbunden ist, und
   - die Verbindung mit der rückwärtigen Fläche des Substrats durch die Dicke des Substrates über den leitenden Pol (14) erfolgt.

2. Integrierter Widerstand nach Anspruch 1, dadurch gekennzeichnet, daß das Band (12) über das andere Ende hinaus verlängert und von einem durch denselben Graben (1) gebildeten Teil (13) umgeben ist, der dazu dient, das Potential des anderen Endes um das Band zu verteilen.

3. Integrierter Widerstand nach einem der Ansprüche 1 oder 2, dadurch gekennzeichnet, daß das Band (12) eine Spirale ist.

4. Integrierter Widerstand nach Anspruch 3, dadurch gekennzeichnet, daß der leitende Pol (14) eine Kreisform aufweist.

5. Integrierter Widerstand nach einem der Ansprüche 1 bis 4, dadurch gekennzeichnet, daß der leitende Pol (14) durch einen Graben gebildet ist, der stark dotiert und vom gleichen Leitungstyp wie das Substrat (10) ist, und daß die elektrische Verbindung zwischen dem Ende des Bandes (12) und dem leitenden Pol (14) über einen Kontaktblock (15) erfolgt.

6. Integrierter Widerstand nach einem der Ansprüche 1 bis 5, dadurch gekennzeichnet, daß das Substrat (10) vom Leitungstyp $N^+$ mit einer epitaktischen Schicht vom Typ N, der den Widerstand bildende Graben (11) vom Leitungstyp $P^+$ und der leitende Pol (14) ein Graben vom Leitungstyp $N^+$ ist.

7. Integrierter Widerstand nach einem der Ansprüche 1 bis 6, dadurch gekennzeichnet, daß zumindest ein Zwischenabgriff (17) einen Kontaktanschluß auf dem Band (12) erlaubt, um eine Teilerbrücke zu realisieren.

# FIG_1

$L$

$V_{REF}$

2

3

4

T

1

# FIG_2

13

d

14

12

A

A

11

10

## FIG_3

13   0V          12        12                15          12          12        0V      13

P+   P+   P+   P+   P+   N+          P+   P+   P+   P+   P+

14

-50V
-100V
-150V
-200V
-250V
-300V
-350V
-400V

N

10

400V

## FIG_4

17                      16

P+              P+        P+

13      12      12

10

N

EP 0 240 435 B1